(19) **Europäisches Patentamt**

**European Patent Office**

**Office européen des brevets**

(11) **EP 0 789 458 B1**

(12) **EUROPEAN PATENT SPECIFICATION**

(45) Date of publication and mention
of the grant of the patent:
**22.08.2001 Bulletin 2001/34**

(51) Int Cl.7: **H03K 17/082**

(21) Application number: **96830054.1**

(22) Date of filing: **09.02.1996**

(54) **Circuit with overload current protection for power transistors**

Schaltung mit Überstromschutz für Leistungstransistoren

Circuit pour protection contre les surintensités dans les transistors de puissance

(84) Designated Contracting States:
**DE FR GB IT**

(43) Date of publication of application:
**13.08.1997 Bulletin 1997/33**

(73) Proprietor: **CO.RI.M.ME.**
**CONSORZIO PER LA RICERCA SULLA**
**MICROELETTRONICA NEL MEZZOGIORNO**
**95121 Catania (IT)**

(72) Inventors:
• **Pulvirenti, Francesco**
**95024 Acireale (Catania) (IT)**

• **Bontempo, Gregorio**
**98051 Barcellona Pozzo Di Gotto (ME) (IT)**

(74) Representative: **Botti, Mario**
**Botti & Ferrari S.r.l.**
**Via Locatelli, 5**
**20124 Milano (IT)**

(56) References cited:
**EP-A- 0 483 744**      **DE-A- 3 821 065**
**US-A- 5 084 668**      **US-A- 5 184 272**
**US-A- 5 361 008**

Printed by Jouve, 75001 PARIS (FR)

**Description**

Field of application

The present invention relates to a circuit for protecting the output stage of an intelligent power actuator from overloads and short circuits. The need to protect these devices, which can be switches, amplifiers and voltage or current regulators, is clear when the power in play is high because an overload or an accidental short circuit could irreversibly damage both the load and the device itself.

Prior art

The output stage of the subject devices is provided by a power transistor and the technique used to limit current is to drive the transistor involved with a negative feedback network which tends to inhibit the transistor itself when the current running in it exceeds a certain predefined threshold. The simplest way to detect the current is to measure the voltage drop on a resistor - termed 'sense' resistor - placed in series with the power transistor.

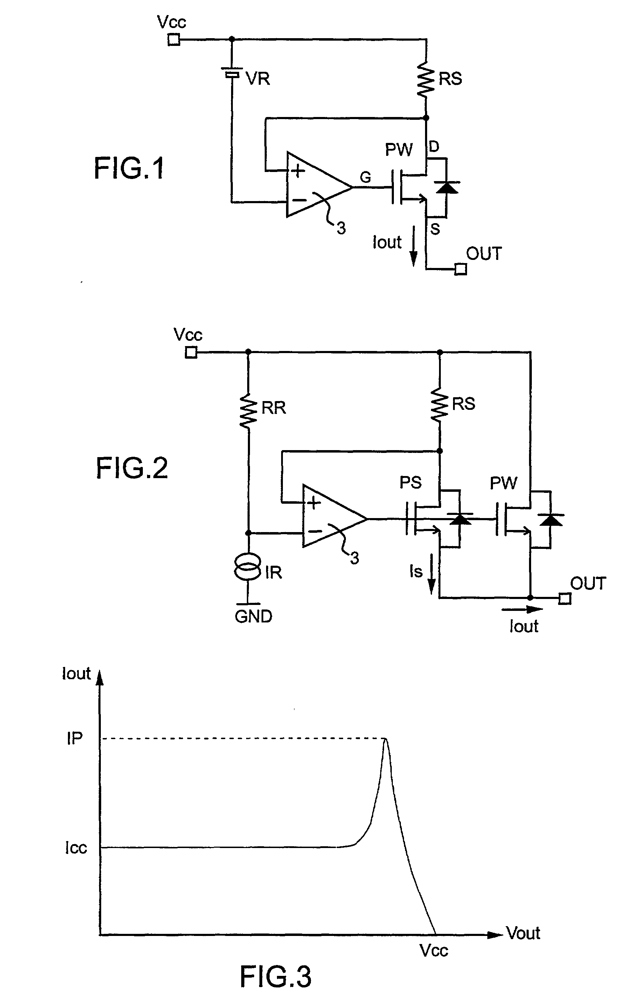

FIG. 1 shows a known circuitry solution for a current limitation circuit in a final stage of a power actuator. A power transistor PW has a principal conduction path D-S placed in series with a sense resistor RS between a positive pole Vcc of a supply voltage generator and an output terminal OUT of the final stage. A comparator 3 provided here by means of an operational amplifier compares the voltage drop on the sense resistor RS, proportional to the current running in the principal conduction path D-S of the power transistor PW with a reference voltage VR. The comparator 3 together with the sense resistor RS and the reference voltage VR constitutes a negative feedback network which tends to inhibit the power transistor PW when the current Iout on the output branch exceeds a certain predefined threshold termed short-circuit current Icc.

The value of the short-circuit current Icc can be readily obtained by equalizing the input voltages of the operational OP because in case of short circuit the operational OP is balanced:

$$I_{CC} = \frac{V_R}{R_S}$$

The value of this current remains constant in the entire interval of the output terminal and even in case of overloads the maximum current delivered by PW is Icc.

This circuitry solution presents the serious problem of increasing the resistance of the output stage because of the presence of the sense resistor RS.

The increasing requirement in recent years for devices with ever higher output current and ever lower voltage drop on the output branch has encouraged the use of MOS transistors in place of the bipolar transistors for the output stage because they permit reduction to the minimum of the voltage drop, allowing minimization of power dissipation.

It is thus evident that measurement of the current directly on the output branch with a sense resistor has the disadvantage of increasing the voltage drop and worsening the thermal performance as well as the electrical performance of the device.

To obviate this shortcoming another prior art much used in these cases is that of measuring, again through a sense resistor, a current proportional to the output current obtained by dividing the power transistor as shown in the diagram of FIG. 2.

In the circuitry solution of FIG. 2 the output current Iout is divided and only a part thereof is measured through a sense resistor RS connected in series with a sense transistor PS with the clear advantage that the output resistance is not altered.

The transistor PS (termed 'power sense') must be well coupled with the power transistor PW and is sized with an area n times smaller than the total area occupied by both the transistors. In this manner, when both the transistors PW and PS work in the saturation region the current running in the PW has a value of Is=Iout/n.

In the case of a short circuit the current Icc can be calculated by equalizing the input voltages of the operational amplifier which has the following value.

$$I_{CC} = n \cdot \left( \frac{R_R}{R_S} \right) \cdot I_R$$

The reference voltage VR is obtained in this circuit by passing the current of the generator IR in the reference resistor RR. Of course this solution does not have the shortcoming of increasing the resistance of the output stage but in this case the measurement proves to be affected by errors when the transistors PS and PW work in a resistive zone. This phenomenon is shown in the chart of FIG. 3 in which is made clear the behaviour of the short circuit Icc as a function of the output voltage Vout.

This phenomenon can be explained by the fact that when the voltage Vout on the output terminal is near the power supply voltage the two transistors PW and PS pass from the saturation region, where they behave as current generators, to the resistive zone and the voltage drop on RS changes the point of operation of PS to modify the value of the mirrored current Is.

Under these operating conditions the mirrored current Is becomes:

$$I_S = \left( \frac{R_S}{R_S + nR_D} \right) \cdot I_{out}$$

where RD is the saturation resistance of the power transistor PW and $nR_D$ is the saturation resistance of the sense transistor PS.

It follows that the value of the limitation current does not remain constant in the entire interval of the output voltage but displays a peak near the resistive region which in certain cases can be more than double the value of the short circuit current.

The peak value Ip which the current Iout can reach is easy to calculate allowing for the assumed value of Is when both transistors work in the resistive region equalizing the input voltages of the operational 3 and is given by the following equation.

$$I_P = \left( 1 + \frac{R_S}{nR_D} \right) \cdot I_{CC}$$

In the case of an overload the limitation current can be moved away from the short circuit current by an amount dependent upon the sense resistor RS and the saturation resistance of the output transistor reaching a maximum value Ip which, from the practical applications, was seen to be double the current Icc.

The circuits described with reference to figures 1 and 2 are simplified schemes corresponding to limitation current circuits described, for example, in the following documents:

-    DE-A-3821065 concerning a "MOS Feldeffekttransistor-Einrichtung", Mihara et al, 5-1-89.

-    US-A-5,184,272 concerning a "High-Side Switch With Overcurrent Protecting Circuit", Koichi Suda et al, Feb. 2, 1993.

-    EP-A-647026 concerning an "Over current protection device for transistor" Fujihara et al, 05-04-95.

The technical problem underlying the present invention is to protect the final transistor of a power actuator from short circuits and overloads with a completely integrated circuitry solution which would not influence the output impedance of the actuator and would permit having a constant limitation current independent of the output voltage value of the actuator.

The technical problem is solved by a limitation circuit for the maximum current delivered by a power transistor of the type indicated and defined in claims 1 to 3.

The technical problem is also solved by a power actuator protected at output from overloads and short circuits and of the type indicated and defined in part of claims 4 to 7.

The characteristics of the present invention are clarified in the detailed description given below of its practical embodiments illustrated by way of non-limiting example in the annexed drawings.

Brief description of the drawings

In the drawings:

FIG. 1 shows a first circuitry solution of a current limitation circuit of known type,

FIG. 2 shows a second circuitry solution of a current limitation circuit of known type,

FIG. 3 shows in a voltage-current diagram the behaviour of the circuit of FIG. 2,

FIG. 4 shows a current limitation circuit circuitry diagram provided in accordance with the present invention,

FIG. 5 shows a circuitry diagram of a final stage of a power actuator incorporating a current limitation circuit provided in accordance with the present invention,

FIG. 6 shows in a voltage-current diagram the behaviour of the circuit of FIG. 5 compared with the behaviour of a circuit of known type.

Detailed description

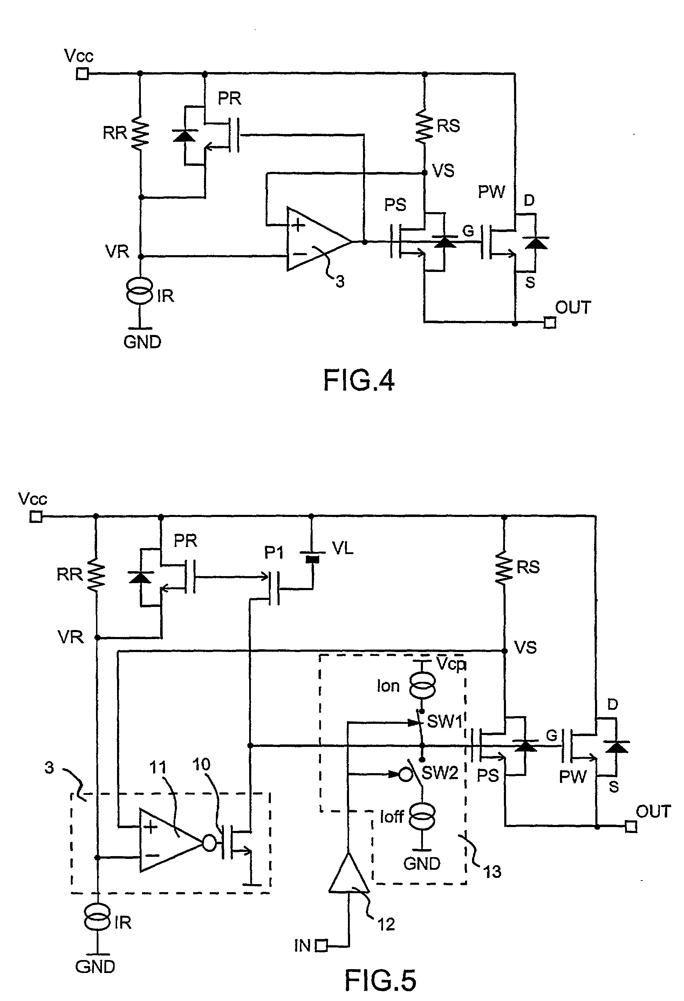

FIG. 4 shows an output current limitation circuit of a power actuator provided in accordance with the present invention.

This circuit is used in a final stage of a 'high side' actuator in which a power transistor PW is used for supplying a load with a positive voltage.

The power transistor PW has a control terminal G termed 'gate', a first principal conduction terminal D termed 'drain', and a second principal conduction terminal S termed 'source'.

The first D and second S principal conduction terminals identify a principal conduction path D-S which is connected between a positive pole Vcc of a power supply generator and the output node OUT of the actuator. In parallel with the path D-S is indicated in the figure a diode DP. This diode is normally present in the integrated MOS power transistors because it is intrinsic to the structure itself.

A network for detection of the current delivered by the power transistor PW comprises a sense transistor PS and a sense resistor RS.

The sense transistor PS has a principal conduction path connected in series with the resistor Rs in parallel with the principal conduction path D-S of the power transistor PW between the positive pole Vcc and the output node OUT of the actuator.

The gate terminals of the transistors PW and PS are connected both to the output of an operational amplifier 3 used as a voltage comparator. A non-inverting input of the amplifier 3 is connected to the common node between the sense transistor PS and the sense resistor RS while an inverting input is connected to the common node between a reference current generator Ir and a resistor RR. The resistor RR and the generator Ir which form a reference network are connected in series between the positive pole Vcc of the power supply generator and a reference GND of the circuit so as to generate a reference voltage VR. In parallel with the resistor RR is placed the conduction path of a transistor, PR having a control terminal - or gate - also connected to the output terminal of the operational amplifier 3.

There is now described the operation of the circuit of FIG. 4.

The basic idea of the innovative solution for eliminating the limitation current peak is that of compensating the effect introduced by the sense resistor RS on the sense transistor PS when the latter works in resistive zone, acting on the reference voltage VR at the inverting input of the operational amplifier 3.

To facilitate the explanation of this concept we shall write the value of the voltage VS at the non-inverting input of the operational amplifier 3 when the two transistors work in resistive zone:

$$V_S = R_S \cdot I_S = \frac{R_S \cdot R_D}{R_S + nR_D} \cdot I_{out} = \frac{1}{n} \cdot (R_S \| nR_D) \cdot I_{out}$$

Hence the voltage Vs is a function of $R_S \| nR_D$, that is of the parallel of the sense resistor Rs with the saturation resistance of the sense transistor PS which is equal to n times the saturation resistance RD of the power transistor PW.

To compensate the effect of the variation of the saturation resistance of the sense transistor PS the circuit in accordance with the present invention calls for reproduction of the same resistance on the other input of the operational amplifier 3 by placing in parallel with the reference resistor RR a MOS transistor PR appropriately sized and coupled with the transistors PS and PW.

To achieve optimal coupling the transistor PR can be designed in the same pocket as the power transistor PW since both have a common drain terminal and must have an area m times smaller than the transistor PS. In addition, the ratio of the resistor RR to the resistor RS must be equal to m, as follows.

$$\frac{R_R}{R_S} = m$$

The saturation resistance of the transistor PR is thus equal to nmRD, that is m times the saturation resistance of the transistor PS which in turn was n times the saturation of the transistor PW.

If we calculate the voltage Vr on the inverting input of the operational amplifier 3 we find the following value:

$$V_R = (R_R \| nmR_D) \cdot I_R = (mR_S \| nmR_D) \cdot I_R = m \cdot (R_S \| nR_D) \cdot I_R$$

We can calculate the current peak Ip in the case of an overload by equalizing the input voltages VS and VR of the operational amplifier 3 as follows.

$$V_S = \frac{1}{n} \cdot (R_S \| nR_D) \cdot I_P \cdot m \cdot (R_S \| nR_D) \cdot I_R = V_R$$

that is

$$I_P = nmI_R = n\frac{R_R}{R_S} \cdot I_R = I_{CC}$$

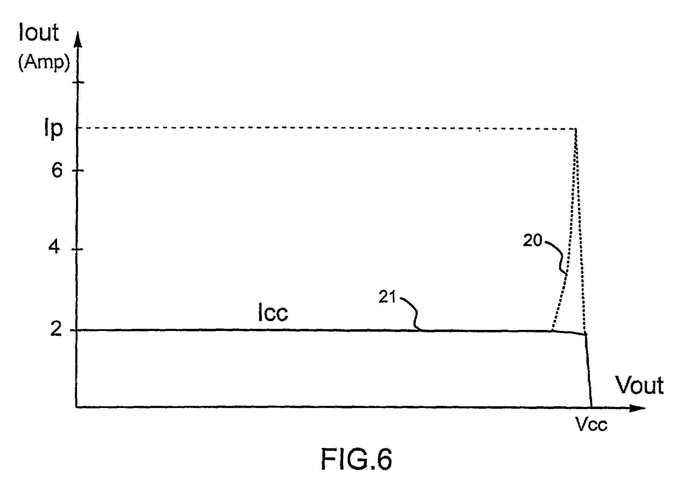

In FIG. 6 is shown the behaviour of the short circuit current Icc as a function of the output voltage Vout for the circuit of FIG. 4, curve 21, and for the circuit provided in accordance with the prior art, curve 20.

It is seen clearly that the current peak of value Ip present in the curve 20 for the prior art circuit is completely eliminated and the short circuit current Icc remains virtually constant over the entire interval.

The solution proposed in the circuit of FIG. 4 was implemented in an intelligent power actuator - or Intelligent High Side Switch - provided in accordance with the electrical diagram of FIG. 5.

In the applicative circuit of FIG. 5 can be distinguished the following circuit parts:

- a power transistor PW having a control terminal G, a first principal conduction terminal D and a second principal conduction terminal S;

- an input stage 12,

- a driver stage 13 of a power transistor PW,

- a limitation circuit for the maximum current delivered by the power transistor PW provided in accordance with the principle of the circuit described in FIG. 4.

The input stage 12 receives an input signal IN and controls the driver stage 13.

The control terminal G of the transistor PW is connected through a first switch SW1 to a first current generator Ion and, through a second switch SW2, to a second current generator Ioff. The switches SW1 and SW2 are electronic switches controlled by two mutually complementary ignition signals coming from the input stage 12.

The first principal conduction terminal D and the second principal conduction terminal S of the power transistor PW identify a principal conduction path D-S which is connected between a positive pole Vcc of a power supply generator and the output node OUT of the actuator itself.

A sense transistor PS has a principal conduction path connected in series with a resistor RS in parallel with the principal conduction path (D-S) of the power transistor PW between the positive pole Vcc and the output node OUT of the actuator.

The gate terminals of the transistors PW and PS are both connected to the output of the pilot stage 13 and to the output of an operational amplifier 3 used as a voltage comparator. The operational amplifier 3 comprises a differential input section 11 and an MOS type output transistor 10.

A non-inverting input of the amplifier 3 is connected to the common node between the sense transistor PS and the sense resistor Rs, while an inverting input is connected to the common node between a reference current generator Ir and a resistor RR. The resistor RR and the generator Ir are connected in series between the positive pole Vcc of the power supply generator and a ground reference GND of the circuit so as to generate a reference voltage VR.

In parallel with the resistor RR is placed the conduction path of a transistor PR having a control terminal - or gate - connected through the conduction path of another transistor P1 to the output terminal of the operational amplifier 3 and then to the control terminals of the transistors PW and PS.

The function of the transistor P1 is that of protecting from overvoltages the control terminal of the transistor PR. It limits the voltage present on this terminal to prevent it from falling below a certain voltage set by the reference voltage VL applied to the control terminal.

The operation of the current limitation circuit used in the intelligent power actuator of FIG. 5 is similar to that described above for the circuit of FIG. 4.

The behaviour of the short circuit current Icc as a function of the output voltage Vout for the circuit of FIG. 5 is shown in the chart of FIG. 6. This chart shows clearly the difference between an actuator of known type, curve 20, and an actuator provided in accordance with the present invention, curve 21. Indeed, the current peak opposite the output voltages near the positive pole Vcc is eliminated.

In the practical embodiment of the actuator of FIG. 5 there were used the following values for the transistors PW, PS and PR, the resistors RS and RR and the current generator IR.

| | |
|---|---|
| Power transistor PW | W = 190mm |
| Sense transistor PS | W = 10mm |
| Reference transistor PR | W = 0.1mm |
| Sense resistor RS | 4Ω |
| Reference resistor RR | 400Ω |
| Reference current IR | 1mA |

where W is the width of the MOS transistor channels. The channel width of the transistor PW must not suggest a single MOS transistor 190mm wide but a transistor designed with several MOSes in parallel and mutually interdigited (for example 190 MOS with W=1mm). This can be achieved thanks to a well known layout technique by alternately superimposing the source and drain diffusions.

With these data, and with n=20 and m=100, there was obtained a short circuit current Icc of 2A and a peak current Ip of 7A was eliminated as may be seen in the chart of FIG. 6.

## Claims

1. Circuit for limitation of the maximum current delivered by a power transistor (PW) having at least one control terminal (G) and two principal conduction terminals (D,S) which identify a principal conduction path (D-S), comprising:

   - a network for detection of the current delivered by the power transistor, coupled to the principal conduction path of the power transistor (PW) to generate a first electrical signal proportional to said current, said detection network comprising a first resistor (RS), as well as a first transistor (PS) having a conduction path placed, in series with the first resistor (RS), between the two principal conduction terminals (D-S) of the power transistor (PW) and having a control terminal connected to the control terminal of the power transistor (PW);

   - a reference network inserted between a first (Vcc) and a second (GND) power supply pole, to generate a second reference electrical signal;

   - an operational amplifier (3) having a first (+) and a second (-) input terminal and an output terminal with the first input terminal (+) connected to said detection network, the second input terminal (-) connected to said reference network and the output terminal being coupled to the control terminal (G) of the power transistor (PW);

   characterized in that the output terminal of the amplifier (3) drives the control terminal (G) of said power transistor (PW) and (3) is coupled also to the reference network to regulate the value of the second reference electrical signal.

2. Circuit in accordance with claim 1, characterized in that said reference network comprises the series of a second resistor (RR) and a reference current generator (IR) connected between said first (Vcc) and said second (GND) power supply pole with the common node between said second resistor (RR) and said current generator (IR) being connected to the second input terminal of the amplifier (3) and in that the second electrical signal is a reference voltage signal (VR).

3. Circuit in accordance with claim 2, characterized in that the output terminal of the amplifier (3) is coupled to the reference network through a second transistor (PR) with said second transistor (PR) having its conduction path connected in parallel with the second resistor (RR) and a control terminal connected to the output terminal of the amplifier (3).

4. Power actuator of the intelligent type comprising:

   - at least one power transistor (PW) having at least one control terminal (G) and two principal conduction terminals (D,S) which identify a principal conduction path (D-S),

   - an input stage (12),

   - a pilot stage (13) of the power transistor (PW),

   characterised in that it further comprises:

   - a circuit for limitation of the maximum current delivered by the power transistor (PW) according to claim 1.

5. Power actuator in accordance with claim 4, characterized in that said reference network comprises the series of a second resistor (RR) and a reference current generator (IR) connected between said first (Vcc) and said second (GND) power supply pole with the common node between said second resistor (RR) and said current generator (IR) being connected to the second input terminal of the amplifier (3) and in that the second electrical signal is a reference voltage signal (VR).

6. Power actuator in accordance with claim 5, characterized in that the output terminal of the amplifier (3) is coupled to the reference network through a second transistor (PR) having a conduction path connected in parallel to the second resistor (RR) and a control terminal coupled to the output terminal of the amplifier (3).

7. Power actuator in accordance with claim 6 and characterized in that the output terminal of the amplifier (3) is coupled to the control terminal of the second transistor (PR) through a third transistor (P1) having a control terminal connected to a reference voltage (VL) and a conduction path connected between the control terminal of the second transistor (PR) and the output terminal of the amplifier (3).

**Patentansprüche**

1. Schaltkreis zum Begrenzen des maximalen Stroms, der von einem Leistungstransistor (PW) mit zumindest einem Steueranschluß (G) und zwei Hauptleitungsanschlüssen (D, S), die einen Hauptleitungspfad (D-S) festlegen, abgegeben wird, mit:

   - einem Netzwerk zum Erfassen des von dem Leistungstransistor abgegebenen Stroms, das mit dem Hauptleitungspfad des Leistungstransistors (PW) gekoppelt ist, um ein erstes elektrisches Signal, das proportional zu dem Strom ist, zu erzeugen, wobei das Erfassungsnetzwerk einen ersten Widerstand (RS) umfaßt sowie einen ersten Transistor (PS) mit einem Leitungspfad, der in Reihe mit dem ersten Widerstand (RS) zwischen den beiden Hauptleitungspfadanschlüssen (D-S) des Leistungstransistors (PW) angeordnet ist, und mit einem Steueranschluß, der mit dem Steueranschluß des Leistungstransistors (PW) verbunden ist,

   - einem Referenznetzwerk, das zwischen einem ersten (Vcc) und einem zweiten (GND) Energieversorgungspol eingefügt ist, um ein zweites elektrisches Referenzsignal zu erzeugen,

   - einem Operationsverstärker (3) mit einem ersten (+) und einem zweiten (-) Eingangsanschluß und einem Ausgangsanschluß, wobei der erste Eingangsanschluß (+) mit dem Erfassungsnetzwerk verbunden ist, der zweite Eingangsanschluß (-) mit dem Referenznetzwerk verbunden ist und der Ausgangsanschluß mit dem Steueranschluß (G) des Leistungstransistors (PW) gekoppelt ist,

   dadurch gekennzeichnet, daß der Ausgangsanschluß des Verstärkers (3) den Steueranschluß (G) des Leistungstransistors (PW) ansteuert und der Verstärker (3) auch mit dem Referenznetzwerk gekoppelt ist, um den Wert des zweiten elektrischen Referenzsignals zu regulieren.

2. Schaltkreis nach Anspruch 1, dadurch gekennzeichnet, daß das Referenznetzwerk die Reihe von einem zweiten Widerstand (RR) und einem Referenzstromgenerator (IR) umfaßt, die zwischen dem ersten (Vcc) und dem zweiten (GND) Energieversorgungspol verbunden ist, wobei der gemeinsame Knotenpunkt zwischen dem zweiten Widerstand (RR) und dem Stromgenerator (IR) mit dem zweiten Eingangsanschluß des Verstärkers (3) verbunden ist, und daß das zweite elektrische Signal ein Referenzspannungssignal (VR) ist.

3. Schaltkreis nach Anspruch 2, dadurch gekennzeichnet, daß der Ausgangsanschluß des Verstärkers (3) mit dem Referenznetzwerk durch einen zweiten Transistor (PR) gekoppelt ist, wobei der zweite Transistor (PR) seinen Leitungspfad parallel verbunden mit dem zweiten Widerstand (RR) hat und einen mit dem Ausgangsanschluß des Verstärkers (3) verbundenen Steueranschluß aufweist.

4. Leistungsstellantrieb der intelligenten Art mit:

- zumindest einem Leistungstransistor (PW) mit mindestens einem Steueranschluß (G) und zwei Hauptleitungsanschlüssen (D, S), die einen Hauptleitungspfad (D-S) festlegen,

- einer Eingangsstufe (12),

- einer Pilotstufe (13) des Leistungstransistors (PW),

dadurch gekennzeichnet, daß der Leistungsstellantrieb weiterhin aufweist:

- einen Schaltkreis zum Begrenzen des maximalen Stroms, der von einem Leistungstransistor (PW) gemäß Anspruch 1 abgegeben wird.

5. Leistungsstellantrieb nach Anspruch 4, dadurch gekennzeichnet, daß das Referenznetzwerk die Reihe von einem zweiten Widerstand (RR) und einem Referenzstromgenerator (IR) umfaßt, die zwischen dem ersten (Vcc) und dem zweiten (GND) Energieversorgunspol verbunden ist, wobei der gemeinsame Knotenpunkt zwischen dem zweiten Widerstand (RR) und dem Stromgenerator (IR) mit dem zweiten Eingangsanschluß des Verstärkers (3) verbunden ist, und daß das zweite elektrische Signal ein Referenzspannungssignal (VR) ist.

6. Leistungsstellantrieb nach Anspruch 5, dadurch gekennzeichnet, daß der Ausgangsanschluß des Verstärkers (3) mit dem Referenznetzwerk durch einen zweiten Transistor (PR) gekoppelt ist, der einen parallel zu dem zweiten Widerstand (RR) verbundenen Leitungspfad und einen mit dem Ausgangsanschluß des Verstärkers (3) gekoppelten Steueranschluß aufweist.

7. Leistungsstellantrieb nach Anspruch 6, dadurch gekennzeichnet, daß der Ausgangsanschluß des Verstärkers (3) mit dem Steueranschluß des zweiten Transistors (PR) durch einen dritten Transistor (P1) gekoppelt ist, der einen mit einer Referenzspannung (VL) verbundenen Steueranschluß und einen zwischen dem Steueranschluß des zweiten Transistors (PR) und dem Ausgangsanschluß des Verstärkers (3) verbundenen Leitungspfad aufweist.

## Revendications

1. Circuit de limitation du courant maximum délivré par un transistor de puissance (PW) ayant au moins une borne de commande (G) et deux bornes de conduction principale (D, S) qui identifient un trajet de conduction principale (D, S), comprenant :

- un réseau de détection du courant délivré par le transistor de puissance, couplé au trajet de conduction principale du transistor de puissance (PW) pour générer un premier signal électrique proportionnel audit courant, ledit réseau de détection comprenant une première résistance (RS), de même qu'un premier transistor (PS) ayant un trajet de conduction placé, en série avec la première résistance (RS), entre les deux bornes de conduction principale (D, S) du transistor de puissance (PW) et ayant une borne de commande connectée à la borne de commande du transistor de puissance (PW) ;
- un réseau de référence inséré entre un premier (Vcc) et un deuxième (GND) pôle d'alimentation, pour générer un deuxième signal électrique de référence ;

- un amplificateur opérationnel (3) ayant une première (+) et une deuxième (-) bornes d'entrée et une borne de sortie, la première borne d'entrée (+) étant connectée audit réseau de détection, la deuxième borne d'entrée (-) étant connectée audit réseau de référence et la borne de sortie étant couplée à la borne de commande (G) du transistor de puissance (PW) ;

**caractérisé en ce que** la borne de sortie de l'amplificateur (3) attaque la borne de commande (G) dudit transistor de puissance (PW) et qu'elle (3) est également couplée au réseau de référence pour réguler la valeur du deuxième signal électrique de référence.

2. Circuit suivant la revendication 1, **caractérisé en ce que** ledit réseau de référence comprend en série une deuxième résistance (RR) et un générateur de courant de référence (IR) connectés entre ledit premier (Vcc) et ledit deuxième (GND) pôles d'alimentation, le noeud commun entre ladite deuxième résistance (RR) et ledit générateur de courant (IR) étant relié à la deuxième borne d'entrée de l'amplificateur (3), et en ce que le deuxième signal électrique est un signal de tension de référence (VR).

3. Circuit suivant la revendication 2, **caractérisé en ce que** la borne de sortie de l'amplificateur (3) est couplée au réseau de référence par un deuxième transistor (PR), ledit deuxième transistor (PR) ayant son trajet de conduction connecté en parallèle avec la deuxième résistance (RR) et une borne de commande connectée à la borne de sortie de l'amplificateur (3).

4. Actionneur de puissance du type intelligent, comprenant :

- au moins un transistor de puissance (PW) ayant au moins une borne de commande (G) et deux bornes de conduction principale (D, S) qui identifient un trajet de conduction principale (D, S),
- un étage d'entrée (12),
- un étage pilote (13) du transistor de puissance (PW),

**caractérisé en ce qu'**il comporte en outre :

- un circuit de limitation du courant maximum délivré par le transistor de puissance (PW) suivant la revendication 1.

5. Actionneur de puissance suivant la revendication 4, **caractérisé en ce que** ledit réseau de référence comprend en série une deuxième résistance (RR) et un générateur de courant de référence (IR) connectés entre ledit premier (Vcc) et ledit deuxième (GND) pôles d'alimentation, le noeud commun entre ladite deuxième résistance (RR) et ledit générateur de courant (IR) étant relié à la deuxième borne d'entrée de l'amplificateur (3), et en ce que le deuxième signal électrique est un signal de tension de référence ( VR).

6. Actionneur de puissance suivant la revendication 5, **caractérisé en ce que** la borne de sortie de l'amplificateur (3) est couplée au réseau de référence par un deuxième transistor (PR) ayant son trajet de conduction connecté en parallèle avec la deuxième résistance (RR) et sa borne de commande couplée à la borne de sortie de l'amplificateur (3).

7. Actionneur de puissance suivant la revendication 6, **caractérisé en ce que** la borne de sortie de l'amplificateur (3) est couplée à la borne de commande du deuxième transistor (PR) par un troisième transistor (P1) ayant sa borne de commande connectée à une tension de référence (VL) et son trajet de conduction connecté entre la borne de commande du deuxième transistor (PR) et la borne de sortie de l'amplificateur (3).

FIG.1

FIG.2

FIG.3

FIG.4

FIG.5

FIG.6